# EUROPEAN PATENT SPECIFICATION

(11) **EP 3 396 232 B1**
(45) Date of publication and mention of the grant of the patent: **17.06.2020**
(21) Application number: 16877936.1
(22) Date of filing: 10.11.2016
(51) Int. Cl.: F21K 9/64, F21S 2/00, F21Y 115/30, G02B 5/02, G02B 5/08, F21V 9/30, H01L 51/56, H05B 33/24, H05B 33/26, H05B 33/14

(54) **LIGHT-EMITTING ELEMENT AND ILLUMINATION DEVICE**
LICHTEMITTIERENDES ELEMENT UND BELEUCHTUNGSVORRICHTUNG
ÉLÉMENT ÉLECTROLUMINESCENT ET DISPOSITIF D'ÉCLAIRAGE

(30) Priority: 24.12.2015 JP 2015251803
(43) Date of publication of application: 31.10.2018
(73) Proprietor: Panasonic Intellectual Property Management Co., Ltd., Osaka-shi, Osaka 540-6207 (JP)
(72) Inventor: AKETA, Takanori, Osaka 540-6207 (JP); MIYAGAWA, Nobuyuki, Osaka 540-6207 (JP); KAMI, Hironori, Osaka 540-6207 (JP); SAITO, Makoto, Osaka 540-6207 (JP); SATO, Toshihiko, Osaka 540-6207 (JP)
(74) Representative: Müller-Boré & Partner Patentanwälte PartG mbB
(86) International application number: PCT/JP2016/004853
(87) International publication number: WO 2017/110031

(56) References cited:
- WO-A1-2012/026206
- WO-A1-2014/123145
- WO-A1-2014/123145
- WO-A1-2014/174618
- WO-A1-2018/042826
- JP-A- 2012 243 624
- JP-A- 2014 116 081
- JP-A- 2015 087 423
- US-A1- 2012 314 411
- US-A1- 2013 107 573

## Description

### TECHNICAL FIELD

The present invention relates to a light-emitting element including a phosphor layer disposed above a substrate and an illumination device including the light-emitting element.

### BACKGROUND ART

Conventionally, illumination devices illuminate a desired light color by emitting, as excitation light, laser light transmitted by a light guide member to a light-emitting element including a phosphor layer disposed on a substrate, causing the phosphor layer to emit light, and converting the light into a desired light color (for example, see Patent Literature 1).

Another conventional light-emitting element is described in the U.S. patent application publication US 2013/107573 A1.

### Citation List

### Patent Literature

PTL 1: Japanese Unexamined Patent Application Publication No. 2015-65142
PTL 2: US 2013/107573 A1

### SUMMARY OF THE INVENTION

### TECHNICAL PROBLEM

In recent years, more efficient dissipation of heat generated in a phosphor layer has been demanded.

Accordingly, the present invention has an object to improve efficiency in heat dissipation in a light-emitting element.

### SOLUTION TO PROBLEM

The light-emitting element of the invention comprises a phosphor layer including phosphor of at least one type; a substrate which has a thermal conductivity higher than a thermal conductivity of the phosphor layer, the substrate having a principal surface above which the phosphor layer is disposed; and a joining part which is interposed between the phosphor layer and the substrate to join the phosphor layer and the substrate together with metal, wherein an adhesion layer and a reflecting layer are interposed between the joining part and the phosphor layer, the adhesion layer being light-transmissive and on a principal surface of the phosphor layer which faces the substrate, the reflecting layer being on a principal surface of the adhesion layer which faces the substrate, and the joining part includes: a first electrode layer which is on the principal surface of the substrate; a second electrode layer which is on a principal surface of the reflecting layer which faces the substrate; and a metal joining layer which is interposed between the first electrode layer and the second electrode layer to join the first electrode layer and the second electrode layer together.

### ADVANTAGEOUS EFFECT OF INVENTION

According to the present invention, efficiency in heat dissipation in a light-emitting element can be improved.

### BRIEF DESCRIPTION OF DRAWINGS

FIG. 1 is a schematic diagram illustrating an overview configuration of an illumination device according to Embodiment.
FIG. 2 is a cross-sectional view illustrating an overview configuration of a light-emitting element according to Embodiment.
FIG. 3 is a cross-sectional view illustrating a state before the light-emitting element according to Embodiment is made.
FIG. 4 is a cross-sectional view illustrating an overview configuration of a light-emitting element according to Variation 1.
FIG. 5 is a cross-sectional view illustrating an overview configuration of a light-emitting element according to Variation 2, not covered by the invention.
FIG. 6 is a cross-sectional view illustrating an overview configuration of a light-emitting element according to Variation 3.
FIG. 7 is a cross-sectional view illustrating an overview configuration of a light-emitting element according to Variation 4.
FIG. 8 is a cross-sectional view illustrating an overview configuration of a light-emitting element according to Variation 5.
FIG. 9 is a cross-sectional view illustrating an overview configuration of a light-emitting element according to Variation 6.

### DESCRIPTION OF EXEMPLARY EMBODIMENT

In the following, a light-emitting element according to Embodiment of the present invention will be described in detail with reference to the drawings. Note that, the embodiment described below shows a preferred example of the present invention. Therefore, the numerical values, shapes, materials, structural components, and the arrangement and connection of the structural components, for instance, presented in the following embodiment are mere examples, and thus are not intended to limit the present invention. Therefore, among the structural components in the embodiment below, structural components not recited in any one of independent claims which indicate the broadest concepts of the present disclosure are described as optional structural components.

Moreover, each diagram is a schematic diagram and is not necessarily illustrated precisely. In each diagram, structural components that are essentially the same share like reference signs.

The following describes Embodiment.

### [Illumination device]

First, an illumination device according to Embodiment is described.

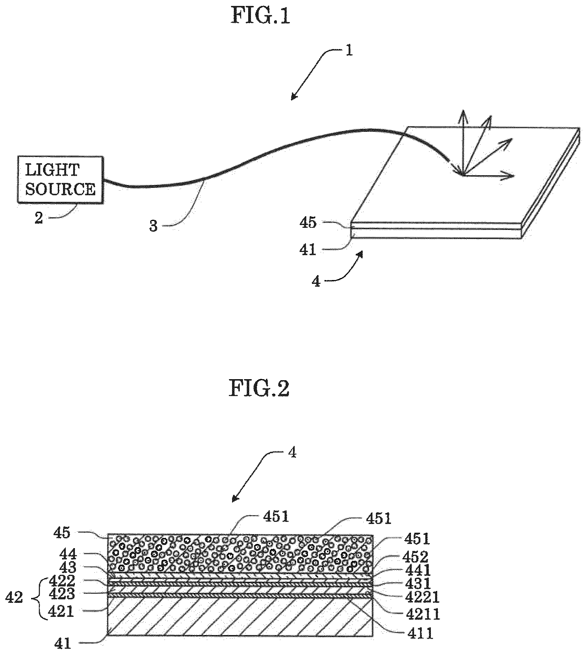

FIG. 1 is a schematic diagram illustrating an overview configuration of an illumination device according to Embodiment.

As illustrated in FIG. 1, illumination device 1 includes light source 2, light guide member 3, and light-emitting element 4.

Light source 2 is a device which generates laser light and supplies the laser light to light-emitting element 4 via light guide member 3, such as an optical fiber, for example. For example, light source 2 is a semiconductor laser element which emits laser light in a violet to blue (430 nm to 490 nm) wavelength.

Light-emitting element 4 uses, as excitation light, the laser light transmitted from light guide member 3 and illuminating a front side to emit white light to the front side.

### [Light-emitting element]

The following describes light-emitting element 4 in detail.

FIG. 2 is a cross-sectional view illustrating an overview configuration of light-emitting element 4 according to Embodiment.

As illustrated in FIG. 2, light-emitting element 4 includes substrate 41, joining part 42, reflecting layer 43, adhesion layer 44, and phosphor layer 45.

The plan-view shape of substrate 41 is, for example, a rectangular shape or a circular shape. Substrate 41 has a thermal conductivity higher than a thermal conductivity of phosphor layer 45. Accordingly, the heat conducted from phosphor layer 45 can be efficiently dissipated from substrate 41. Specifically, substrate 41 is formed from a metallic material such as Cu and Al. Note that, substrate 41 may be formed from a material other than a metallic material as long as substrate 41 has a thermal conductivity higher than the thermal conductivity of phosphor layer 45. Examples of such a material other than a metallic material include glass and sapphire. Moreover, in order to further improve the heat dissipation, for example, a heat sink such as a mirror heat sink may be abutted on substrate 41 and attached to substrate 41.

Phosphor layer 45 is disposed above principal surface 411, which is one of the principal surfaces of substrate 41, via joining part 42, reflecting layer 43, and adhesion layer 44. Phosphor layer 45 is formed in a shape having the same plan-view shape as substrate 41. Moreover, phosphor layer 45 includes, for example, particles of a phosphor (phosphor particles 451) in a dispersed state, which are excited by laser light and emit fluorescence. Phosphor particles 451 emit fluorescence by irradiation with laser light. Therefore, an outward principal surface of phosphor layer 45 is a light-emitting surface.

In Embodiment, phosphor layer 45 emits white light and includes three types of phosphor particles in a suitable proportion. The three types of phosphors are: a first phosphor which emits red light, a second phosphor which emits blue light, and a third phosphor which emits green light, by irradiation with laser light.

Although the types and the characteristics of the phosphors are not particularly limited, a phosphor which is highly resistant to heat may be used, since relatively high-output laser light is used as the excitation light. Furthermore, although the type of a base material which holds a phosphor in a dispersed state is not particularly limited, a base material having a high transparency for the wavelength of the excitation light and the wavelength of light emitted from the phosphor may be used. Specifically, examples of the base material include a base material formed from glass or ceramic.

Moreover, phosphor layer 45 may be a polycrystal or monocrystal of one type of phosphor.

Adhesion layer 44 is disposed on principal surface 452 of phosphor layer 45 which faces substrate 41. Adhesion layer 44 is formed from a chemical compound which is light-transmissive, and is adhered to phosphor layer 45 and reflecting layer 43. Adhesion layer 44 is formed by forming a film of a chemical compound on principal surface 452 of phosphor layer 45, using a commonly-known method for producing a film, such as sputtering and plating. Specifically, examples of the chemical compound which forms adhesion layer 44 include an oxide, a halide, a nitride, and a fluoride. Examples of the oxide include metallic oxides such as ITO, IZO, and Al₂O₃. Use of a metallic oxide improves the adhesion to both of phosphor layer 45 and reflecting layer 43.

Reflecting layer 43 is disposed on principal surface 441 of adhesion layer 44 which faces substrate 41. Reflecting layer 43 reflects laser light and the light emitted from phosphor particles 451. Therefore, reflecting layer 43 is formed from a material having a high reflectance for laser light and the light emitted from phosphor particles 451. Specifically, examples of the material having a high reflectance include metallic materials such as Ag and Al. Reflecting layer 43 is formed by forming a film of a metallic material on principal surface 441 of adhesion layer 44, using a commonly-known method for producing a film, such as sputtering and plating. Moreover, for a layer including at least one of these metallic materials, an enhanced reflection film such as a dielectric multilayer film may be formed.

Joining part 42 includes first electrode layer 421, second electrode layer 422, and metal joining layer 423.

First electrode layer 421 is disposed on principal surface 411 of substrate 41 which faces phosphor layer 45. First electrode layer 421 is formed from, for example, a metallic material such as Au, Ag, Ni, Pd, and Ti. First electrode layer 421 is formed by forming a film of a metallic material on principal surface 411 of substrate 41, using a commonly-known method for producing a film, such as sputtering and plating.

Second electrode layer 422 is disposed on principal surface 431 of reflecting layer 43 which faces substrate 41. Second electrode layer 422 is formed from, for example, a metallic material such as Au, Ag, Ni, Pd, and Ti. Second electrode layer 422 is formed by forming a film of a metallic material on principal surface 431 of reflecting layer 43, using a commonly-known method for producing a film, such as sputtering and plating.

Metal joining layer 423 is disposed between principal surface 4211 of first electrode layer 421 which faces phosphor layer 45 and principal surface 4221 of second electrode layer 422 which faces substrate 41. Metal joining layer 423 includes a metallic material which can perform joining. Examples of the metallic material which can be used for joining include an AuSn-based solder material, an AuGe-based solder material, and a SnAgCu-based solder material.

Here, a state before light-emitting element 4 is made is described.

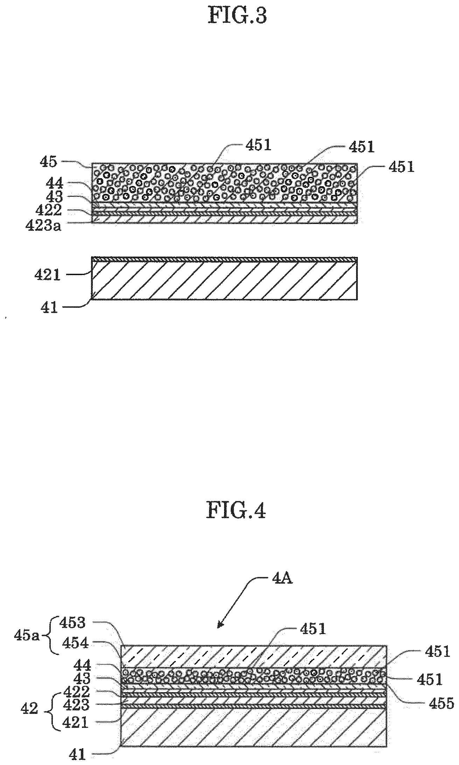

FIG. 3 is a cross-sectional view illustrating the state before light-emitting element 4 according to Embodiment is made.

As illustrated in FIG. 3, before light-emitting element 4 is made, first electrode layer 421 is combined with substrate 41 in advance, and adhesion layer 44, reflecting layer 43, second electrode layer 422, and solder material 423a are combined with phosphor layer 45 in advance. After first electrode layer 421 is abutted on solder material 423a, solder material 423a is melted by heating, and first electrode layer 421 and second electrode layer 422 are joined with the melted solder material. Accordingly, the solder material is interposed between first electrode layer 421 and second electrode layer 422, and becomes metal joining layer 423 which joins first electrode layer 421 and second electrode layer 422 together.

Note that, before light-emitting element 4 is made, solder material 423a may be combined with second electrode layer 422 in advance. Moreover, solder material 423a may be a separate material from first electrode layer 421 and second electrode layer 422, and may be attached to first electrode layer 421 and second electrode layer 422 when light-emitting element 4 is made.

### [Operation of illumination device]

Next, the operation of illumination device 1 is described.

When phosphor layer 45 of light-emitting element 4 is irradiated with laser light via light guide member 3 from light source 2, part of laser light hits phosphor particles 451 directly. Moreover, some of the laser light which has not directly hit phosphor particles 451 is reflected by reflecting layer 43 via adhesion layer 44 and hits phosphor particles 451. The laser light which has reached phosphor particles 451 is converted to white light by phosphor particles 451 and emitted. Some of the white light emitted from phosphor particles 451 is directly emitted outside from phosphor layer 45. Moreover, some of the other light emitted from phosphor particles 451 is reflected by reflecting layer 43 via adhesion layer 44, and emitted outside from phosphor layer 45.

Although phosphor particles 451 generate heat during irradiation with laser light, the heat is transmitted to substrate 41 via adhesion layer 44, reflecting layer 43, second electrode layer 422, metal joining layer 423, and first electrode layer 421, and the heat is dissipated.

### [Effects etc.]

As described above, according to Embodiment, illumination device 1 includes light-emitting element 4 and light source 2 which emits excitation light for exciting phosphor particles 451 of light-emitting element 4. Moreover, light-emitting element 4 includes: phosphor layer 45 including phosphor particles 451 of at least one type; substrate 41 which has a thermal conductivity higher than a thermal conductivity of phosphor layer 45, the substrate having principal surface 411 above which phosphor layer 45 is disposed; joining part 42 which is interposed between layer 45 and substrate 41 to join phosphor layer 45 and substrate 41 together with metal. Adhesion layer 44 and reflecting layer 43 are interposed between joining part 42 and phosphor layer 45. Adhesion layer 44 is light-transmissive and is on principal surface 452 of phosphor layer 45 which faces substrate 41, and reflecting layer 43 is on principal surface 441 of adhesion layer 44 which faces substrate 41.

Here, when phosphor layer 45 and substrate 41 are bonded together with resin, the resin will be thermally a barrier and heat radiation efficiency will be decreased. However, substrate 41 having a thermal conductivity higher than the thermal conductivity of phosphor layer 45 is joined to phosphor layer 45 with metal by joining part 42 as described above. Thus, heat can be smoothly transferred from phosphor layer 45 to substrate 41, and the heat dissipation efficiency can be improved.

In addition, since reflecting layer 43 is disposed below phosphor layer 45 via adhesion layer 44 which is light-transmissive, the white light emitted from phosphor particles 451 can be reflected by reflecting layer 43, and can be emitted outside phosphor layer 45. In other words, the white light which would be absorbed by joining part 42 if there is no reflecting layer 43 can be emitted outside by reflecting layer 43. Thus, luminous efficiency can be improved. Moreover, generation of heat by absorbing white light can also be suppressed.

Here, when reflecting layer 43 is directly disposed on phosphor layer 45, a minute space may be formed between reflecting layer 43 and phosphor layer 45. Such a minute space reduces the heat transmission from phosphor layer 45 to substrate 41. However, since phosphor layer 45 and reflecting layer 43 are adhered to adhesion layer 44, a decrease in the heat transfer property due to the space can be suppressed. Therefore, the heat dissipation efficiency can be improved.

Note that, in order to further improve heat dissipation efficiency, each of first electrode layer 421, adhesion layer 44, reflecting layer 43, second electrode layer 422, and metal joining layer 423 may be formed from a material having a thermal conductivity higher than the thermal conductivity of phosphor layer 45.

Moreover, joining part 42 includes: first electrode layer 421 which is on principal surface 41 of substrate 411; second electrode layer 422 which is on principal surface 431 of reflecting layer 43 which faces substrate 41; and metal joining layer 423 which is interposed between first electrode layer 421 and electrode layer 422 to join first electrode layer 421 and second electrode layer 422 together.

Accordingly, since metal joining layer 423 is interposed between first electrode layer 421 and second electrode layer 422, joining by metal joining layer 423 can be easily achieved by applying electric current to first electrode layer 421 and second electrode layer 422 at the time of manufacture.

Moreover, adhesion layer 44 is formed from a metallic oxide.

Accordingly, since adhesion layer 44 includes a metallic oxide, the adhesion to both of phosphor layer 45 and reflecting layer 43 can be improved.

### VARIATION 1

Next, Variation 1 according to Embodiment is described.

FIG. 4 is a cross-sectional view illustrating an overview configuration of light-emitting element 4A according to Variation 1. Specifically, FIG. 4 corresponds to FIG. 2. Note that, in the subsequent description, components that are essentially the same as light-emitting element 4 according to Embodiment share like reference numerals, and explanations thereof are omitted. The following only describes points different from Embodiment.

The above embodiment has described, as an example, the case where phosphor particles 451 are distributed generally uniformly on the entire phosphor layer 45. However, Variation 1 describes light-emitting element 4A in which phosphor particles 451 are disposed on a side of phosphor layer 45a which is closer to substrate 41.

As illustrated in FIG. 4, phosphor layer 45a has a two-layer structure in which first layer 453 and second layer 454 are stacked. First layer 453 is formed from, for example, a light-transmissive plate material such as glass, and second layer 454 is formed from inorganic binder 455 containing many phosphor particles 451. Since second layer 454 is disposed on the side of phosphor layer 45a which is closer to substrate 41, and first layer 453 is disposed on the side of phosphor layer 45a which is away from substrate 41, phosphor particles 451 are disposed on the side of phosphor layer 45a which is closer to substrate 41.

As described above, since phosphor particles 451 are disposed closer to substrate 41 in phosphor layer 45a, the space between each of phosphor particles 451 and substrate 41 can be reduced. Therefore, heat can be efficiently transferred to a substrate 41 side of the light-emitting element.

Moreover, since phosphor layer 45a has the two-layer structure, second layer 454 containing phosphor particles 451 can also be protected by first layer 453.

Note that, phosphor layer 45a does not need to have the two-layer structure. When the phosphor layer is formed, phosphor particles may be collected toward one of the principal surfaces of the phosphor layer, and the principal surface may be disposed on the side of phosphor layer 45a which is closer to substrate 41.

### VARIATION 2

Next, Variation 2 according to Embodiment is described.

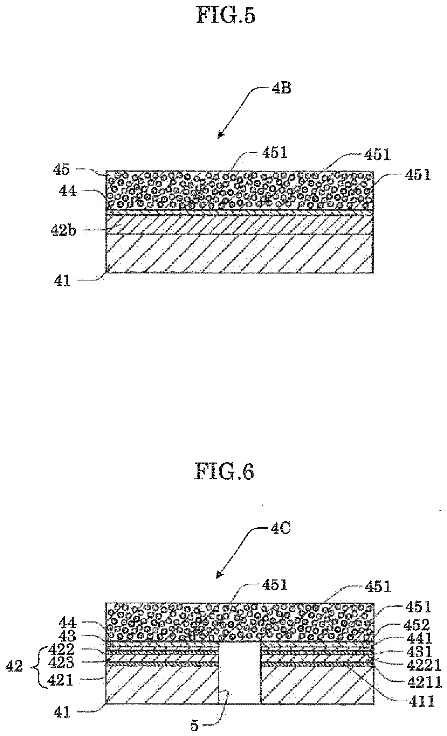

FIG. 5 is a cross-sectional view illustrating an overview configuration of light-emitting element 4B according to Variation 2. FIG. 5 is a mere example and is not covered by the present invention. Specifically, FIG. 5 corresponds to FIG. 2.

The above embodiment has described the case where joining part 42 includes first electrode layer 421, second electrode layer 422, and metal joining layer 423; as is the case in the present invention. Variation 2 describes light-emitting element 4B in which joining part 42b includes sintered silver nanoparticles Variation 2 is a mere example and is not part of the invention, defined by the appended claims.

As illustrated in FIG. 5, joining part 42b is interposed between adhesion layer 44 and substrate 41. As mentioned above, since joining part 42b is formed by sintering silver nanoparticles, joining with metal can be performed even without first electrode layer 421 and second electrode layer 422. Since reflectance of the silver nanoparticles is improved by being sintered, the silver nanoparticles can also serve as a reflecting layer. In other words, reflecting layer 43 in light-emitting element 4 according to Embodiment can be omitted, and thus manufacturing efficiency can be improved.

### VARIATION 3

Next, Variation 3 according to Embodiment is described.

FIG. 6 is a cross-sectional view illustrating an overview configuration of light-emitting element 4C according to Variation 3. Specifically, FIG. 6 corresponds to FIG. 2.

As illustrated in FIG. 6, in light-emitting element 4C, through hole 5 penetrates through substrate 41, joining part 42, reflecting layer 43, and adhesion layer 44 to extend continuously in a normal direction of primary surface 411 of substrate 41. Through hole 5 can serve as an optical path for excitation light (laser light) which enters from the substrate 41 side of the light-emitting element to excite phosphor particles 451 in phosphor layer 45. Accordingly, white light can be emitted to the travelling direction of excitation light. Moreover, since light source 2 and light guide member 3 can be disposed on the back side of substrate 41, the whole illumination device 1 can be made compact.

Note that, although variation 3 has described the case where through hole 5 extends continuously in the normal direction of principal surface 411 of substrate 41 as an example, through hole 5 may extend continuously in any direction as long as it is a direction that intersects with principal surface 411.

### VARIATION 4

Next, Variation 4 according to Embodiment is described.

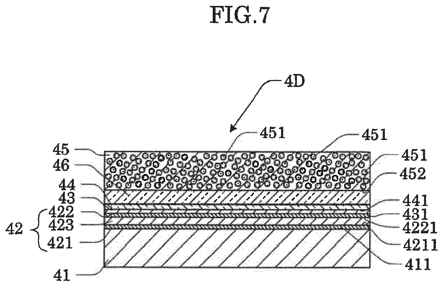

FIG. 7 is a cross-sectional view illustrating an overview configuration of light-emitting element 4D according to Variation 4. Specifically, FIG. 7 corresponds to FIG. 2.

Light-emitting element 4D according to Variation 4 differs from light-emitting element 4 according to Embodiment in that light-emitting element 4D includes diffusion layer 46. Specifically, as illustrated in FIG. 7, light-emitting element 4D includes diffusion layer 46 which diffuses light and is interposed between phosphor layer 45 and adhesion layer 44. Diffusion layer 46 diffuses laser light which is excitation light, and fluorescence which is emitted by phosphor particles 451. Diffusion layer 46 is formed, for example, by dispersing diffusion particles such as silica-based particles or titanium-based particles in an inorganic sealing member such as glass. Since diffusion layer 46 is interposed between phosphor layer 45 and reflecting layer 43 as described above, the laser light and the fluorescence can be diffused by diffusion layer 46 and their light colors can be mixed. Therefore, uniform white light can be achieved.

Note that Variation 4 has described, as an example, the case where diffusion layer 46 is interposed between phosphor layer 45 and adhesion layer 44. However, it is sufficient that diffusion layer 46 is interposed between phosphor layer 45 and reflecting layer 43. In other words, diffusion layer 46 may be interposed between adhesion layer 44 and reflecting layer 43.

### VARIATION 5

Next, Variation 5 according to Embodiment is described.

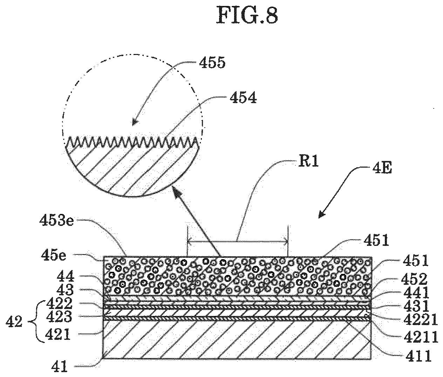

FIG. 8 is a cross-sectional view illustrating an overview configuration of light-emitting element 4E according to Variation 5. Specifically, FIG. 8 corresponds to FIG. 2.

Light-emitting element 4E according to Variation 5 differs from light-emitting element 4 according to Embodiment in that the surface of phosphor layer 45e has uneven pattern 455. Specifically, as illustrated in FIG. 8, uneven pattern 455 in which fine depressions and projections 454 are repeated is formed in region R1 on surface 453e of phosphor layer 45e which is a principal surface opposite to the principal surface of phosphor layer facing substrate 41. Region R1 is to be irradiated with laser light. Uneven pattern 455 is formed by the nanoimprint technique or blast processing, for example. The surface roughness of region R1 due to uneven pattern 455 may be a surface roughness having a wavelength greater than or equal to the wavelength of laser light. Accordingly, since laser light is diffused in region R1 on surface 453e of phosphor layer 45e, uniform white light can be achieved.

Note that, although the case where uneven pattern 455 is formed only in region R1 on surface 453e of phosphor layer 45e is given as an example in Variation 5, uneven pattern 455 may be formed at least in region R1. In other words, uneven pattern 455 may be formed on the entire surface 453e of phosphor layer 45e.

### VARIATION 6

Next, Variation 6 according to Embodiment is described.

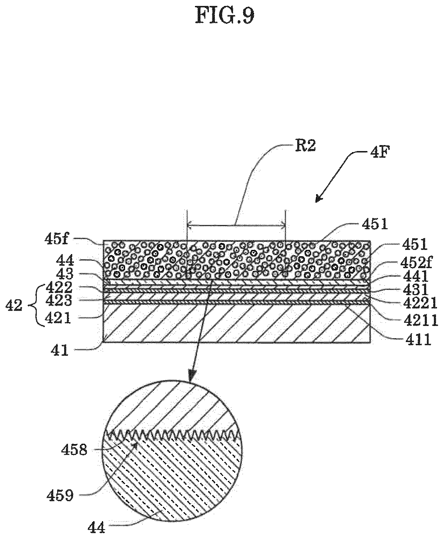

FIG. 9 is a cross-sectional view illustrating an overview configuration of light-emitting element 4F according to Variation 6. Specifically, FIG. 9 corresponds to FIG. 2.

Light-emitting element 4F according to Variation 6 differs from light-emitting element 4 according to Embodiment in that principal surface 452f of phosphor layer 45f has uneven pattern 459. Specifically, as illustrated in FIG. 9, uneven pattern 459 in which minute depressions and projections 458 are repeated is formed in region R2 on principal surface 452f of phosphor layer 45f which faces substrate 41. Region R2 is to be irradiated with laser light. Uneven pattern 459 is formed by the nanoimprint technique or blast processing, for example. Surface roughness formed by uneven pattern 459 may be a surface roughness greater than or equal to the wavelength of laser light. Accordingly, since laser light is diffused in region R2 of principal surface 452f of phosphor layer 45f, uniform white light can be achieved.

Note that, although the case where uneven pattern 459 is formed only in region R2 on principal surface 452f of phosphor layer 45f is given as an example in Variation 6, uneven pattern 459 may be formed in at least region R2. In other words, uneven pattern 459 may be formed on the entire principal surface 452f of phosphor layer 45f.

### OTHER EMBODIMENTS

While the illumination device according to the present invention has been described above based on Embodiment and Variations 1 to 6, the present invention is covered by the appended claims and encompasses Embodiment and Variations 1, 3-6. Variation 2 is a mere example, not covered by the invention.

Although Embodiment and Variations 1 to 6 have described as an example the case where light-emitting element 4 is applied to illumination device 1, light-emitting element 4 may also be used in other illumination systems. Examples of the other illumination systems include a projector, headlights mounted in vehicle, and so on. When light-emitting element 4 is applied to a projector, light-emitting element 4 is used as a phosphor wheel.

Moreover, a reflection inhibition layer such as an AR coat layer may be disposed on the surface of phosphor layer 45 which is opposite to principal surface 452 of phosphor layer 45, i.e., on the surface from which light is emitted. This improves the light extraction efficiency.

The present invention is defined by the appended claims.

### REFERENCE MARKS IN THE DRAWINGS

- 1: illumination device
- 2: light source
- 4, 4A, 4B, 4C: light-emitting element
- 5: through hole
- 41: substrate
- 42, 42b: joining part
- 43: reflecting layer
- 44: adhesion layer
- 45, 45a: phosphor layer
- 46: diffusion layer
- 411, 441: principal surface
- 421: first electrode layer
- 422: second electrode layer
- 423: metal joining layer
- 451: phosphor particles (phosphor)
- 452,452e: principal surface
- 453e: surface

## Claims

1. A light-emitting element (4, 4A, 4B, 4C), comprising:
a phosphor layer (45, 45a) including phosphor of at least one type;
a substrate (41) which has a thermal conductivity higher than a thermal conductivity of the phosphor layer (45, 45a), the substrate (41) having a principal surface (411) above which the phosphor layer (45, 45a) is disposed; and
a joining part (42, 42b) which is interposed between the phosphor layer (45, 45a) and the substrate (41) to join the phosphor layer (45, 45a) and the substrate (41) together with metal,
wherein an adhesion layer (44) and a reflecting layer (43) are interposed between the joining part and the phosphor layer (45, 45a), the adhesion layer (44) being light-transmissive and on a principal surface (452, 452e) of the phosphor layer (45, 45a) which faces the substrate (41), the reflecting layer (43) being on a principal surface (441) of the adhesion layer (44) which faces the substrate (41), and
the joining part (42, 42b) includes:
a first electrode layer (421) which is on the principal surface (411) of the substrate (41);
a second electrode layer (422) which is on a principal surface of the reflecting layer (43) which faces the substrate (41); and
a metal joining layer (423) which is interposed between the first electrode layer (421) and the second electrode layer (422) to join the first electrode layer (421) and the second electrode layer (422) together.

2. The light-emitting element (4, 4A, 4B, 4C) according to claim 1,
wherein the phosphor is disposed on a side of the phosphor layer (45, 45a) which is closer to the substrate (41).

3. The light-emitting element (4, 4A, 4B, 4C) according to any one of claims 1 to 2,
wherein the adhesion layer (44) comprises a metallic oxide.

4. The light-emitting element (4, 4A, 4B, 4C) according to any one of claims 1 to 3,
wherein a through hole (5) penetrates through the substrate (41), the joining part (42, 42b), the reflecting layer (43), and the adhesion layer (44) to extend continuously in a direction intersecting with the principal surface (411) of the substrate (41), and
the through hole (5) serves as an optical path for excitation light which enters from a substrate side of the light-emitting element (4, 4A, 4B, 4C) to excite the phosphor.

5. The light-emitting element (4, 4A, 4B, 4C) according to any one of claims 1 to 4,
wherein a diffusion layer (46) which diffuses light is interposed between the phosphor layer (45, 45a) and the reflecting layer (43).

6. The light-emitting element (4, 4A, 4B, 4C) according to any one of claims 1 to 5,
wherein a surface of the phosphor layer (45, 45a) which is opposite to the principal surface (452, 452e) of the phosphor layer (45, 45a) facing the substrate (41) includes a region which is to be irradiated with the excitation light for exciting the phosphor, the region having a surface roughness with a wavelength greater than or equal to a wavelength of the excitation light.

7. The light-emitting element (4, 4A, 4B, 4C) according to any one of claims 1 to 5,
wherein the principal surface (452, 452e) of the phosphor layer (45, 45a) which faces the substrate (41) includes a region which is to be irradiated with the excitation light for exciting the phosphor, the region having a surface roughness with a wavelength greater than or equal to a wavelength of the excitation light.

8. An illumination device (1), comprising:
the light-emitting element (4, 4A, 4B, 4C) according to any one of claims 1 to 7; and
a light source (2) which emits excitation light for exciting the phosphor of the light-emitting element (4, 4A, 4B, 4C).

## Patentansprüche

1. Ein lichtemittierendes Element (4, 4A, 4B, 4C), das Folgendes umfasst:
eine Phosphorschicht (45, 45a), die Phosphor mindestens eines Typs enthält;
ein Substrat (41), das eine höhere Wärmeleitfähigkeit hat als die Phosphorschicht (45, 45a), wobei das Substrat (41) eine Hauptoberfläche (411) hat, über der die Phosphorschicht (45, 45a) angeordnet ist; und
ein Verbindungsteil (42, 42b), das zwischen der Phosphorschicht (45, 45a) und dem Substrat (41) angeordnet ist, um die Phosphorschicht (45, 45a) und das Substrat (41) zusammen mit Metall zu verbinden,
wobei eine Haftschicht (44) und eine reflektierende Schicht (43) zwischen dem Verbindungsteil und der Phosphorschicht (45, 45a) angeordnet sind, wobei die Haftschicht (44) lichtdurchlässig ist und sich auf einer Hauptoberfläche (452, 452e) der Phosphorschicht (45, 45a) befindet, die dem Substrat (41) zugewandt ist, wobei sich die reflektierende Schicht (43) auf einer Hauptoberfläche (441) der Haftschicht (44) befindet, die dem Substrat (41) zugewandt ist, und
wobei das Verbindungsteil (42, 42b) Folgendes enthält:
eine erste Elektrodenschicht (421), die sich auf der Hauptoberfläche (411) des Substrats (41) befindet;
eine zweite Elektrodenschicht (422), die sich auf einer Hauptoberfläche der reflektierenden Schicht (43) befindet, die dem Substrat (41) zugewandt ist; und
eine metallische Verbindungsschicht (423), die zwischen der ersten Elektrodenschicht (421) und der zweiten Elektrodenschicht (422) angeordnet ist, um die erste Elektrodenschicht (421) und die zweite Elektrodenschicht (422) miteinander zu verbinden.

2. Das lichtemittierende Element (4, 4A, 4B, 4C) nach Anspruch 1, wobei der Phosphor auf einer Seite der Phosphorschicht (45, 45a) angeordnet ist, die näher am Substrat (41) liegt.

3. Das lichtemittierende Element (4, 4A, 4B, 4C) nach irgendeinem der Ansprüche von 1 bis 2,
wobei die Haftschicht (44) ein Metalloxid umfasst.

4. Das lichtemittierende Element (4, 4A, 4B, 4C) irgendeinem der Ansprüche von 1 bis 3,
wobei ein Durchgangsloch (5) das Substrat (41), das Verbindungsteil (42, 42b), die reflektierende Schicht (43) und die Haftschicht (44) durchdringt, um sich kontinuierlich in einer Richtung zu erstrecken, die die Hauptoberfläche (411) des Substrats (41) schneidet, und wobei
das Durchgangsloch (5) als optischer Pfad für Anregungslicht dient, das von einer Substratseite des lichtemittierenden Elements (4, 4A, 4B, 4C) eintritt, um den Phosphor anzuregen.

5. Das lichtemittierende Element (4, 4A, 4B, 4C) nach irgendeinem der Ansprüche von 1 bis 4,
wobei eine Diffusionsschicht (46), die Licht streut, zwischen der Phosphorschicht (45, 45a) und der reflektierenden Schicht (43) angeordnet ist.

6. Das lichtemittierende Element (4, 4A, 4B, 4C) nach irgendeinem der Ansprüche von 1 bis 5,
wobei eine Oberfläche der Phosphorschicht (45, 45a), die der Hauptoberfläche (452, 452e) der Phosphorschicht (45, 45a), die dem Substrat (41) zugewandt ist, gegenüberliegt, einen Bereich beinhaltet, der mit dem Anregungslicht zum Anregen des Phosphors zu bestrahlen ist, wobei der Bereich eine Oberflächenrauhigkeit mit einer Wellenlänge aufweist, die größer oder gleich einer Wellenlänge des Anregungslichts ist.

7. Das lichtemittierende Element (4, 4A, 4B, 4C) nach irgendeinem der Ansprüche von 1 bis 5,
wobei die Hauptoberfläche (452, 452e) der Phosphorschicht (45, 45a), die dem Substrat (41) zugewandt ist, einen Bereich beinhaltet, der mit dem Anregungslicht zum Anregen des Phosphors zu bestrahlen ist, wobei der Bereich eine Oberflächenrauhigkeit mit einer Wellenlänge aufweist, die größer oder gleich einer Wellenlänge des Anregungslichts ist.

8. Eine Beleuchtungsvorrichtung (1), die Folgendes umfasst:
das lichtemittierende Element (4, 4A, 4B, 4C) nach irgendeinem der Ansprüche von 1 bis 7; und
eine Lichtquelle (2), die Anregungslicht zur Anregung des Phosphors des lichtemittierenden Elements (4, 4A, 4B, 4C) aussendet.

## Revendications

1. Un élément émetteur de lumière (4, 4A, 4B, 4C), comprenant :
une couche de phosphore (45, 45a) incluant du phosphore d'au moins un type ;
un substrat (41) qui présente une conductivité thermique supérieure à la conductivité thermique de la couche de phosphore (45, 45a), le substrat (41) ayant une surface principale (411) au-dessus de laquelle est disposée la couche de phosphore (45, 45a); et
une pièce de jonction (42, 42b) qui est interposée entre la couche de phosphore (45, 45a) et le substrat (41) pour joindre la couche de phosphore (45, 45a) et le substrat (41) ensemble avec du métal,
sachant qu'une couche d'adhérence (44) et une couche réfléchissante (43) sont interposées entre la pièce de jonction et la couche de phosphore (45, 45a), la couche d'adhérence (44) étant transparente à la lumière et sur une surface principale (452, 452e) de la couche de phosphore (45, 45a) qui fait face au substrat (41), la couche réfléchissante (43) étant sur une surface principale (441) de la couche d'adhérence (44) qui fait face au substrat (41), et que
la pièce de jonction (42, 42b) inclut :
une première couche d'électrode (421) qui se trouve sur la surface principale (411) du substrat (41) ;
une deuxième couche d'électrode (422) qui se trouve sur une surface principale de la couche réfléchissante (43) qui fait face au substrat (41); et
une couche d'assemblage métallique (423) qui est intercalée entre la première couche d'électrode (421) et la deuxième couche d'électrode (422) pour joindre la première couche d'électrode (421) à la deuxième couche d'électrode (422).

2. L'élément émetteur de lumière (4, 4A, 4B, 4C) d'après la revendication 1,
sachant que le phosphore est disposé sur un côté de la couche de phosphore (45, 45a) qui est plus proche du substrat (41).

3. L'élément émetteur de lumière (4, 4A, 4B, 4C) d'après l'une quelconque des revendications de 1 à 2,
sachant que la couche d'adhérence (44) comprend un oxyde métallique.

4. L'élément émetteur de lumière (4, 4A, 4B, 4C) d'après l'une quelconque des revendications de 1 à 3,
sachant qu'un trou traversant (5) pénètre à travers le substrat (41), la pièce de jonction (42, 42b), la couche réfléchissante (43) et la couche d'adhérence (44) pour s'étendre de manière continue dans une direction coupant la surface principale (411) du substrat (41), et que
le trou traversant (5) sert de chemin optique pour la lumière d'excitation qui entre par un côté du substrat de l'élément émetteur de lumière (4, 4A, 4B, 4C) pour exciter le phosphore.

5. L'élément émetteur de lumière (4, 4A, 4B, 4C) d'après l'une quelconque des revendications de 1 à 4,
sachant qu'une couche de diffusion (46) qui diffuse la lumière est interposée entre la couche de phosphore (45, 45a) et la couche réfléchissante (43).

6. L'élément émetteur de lumière (4, 4A, 4B, 4C) d'après l'une quelconque des revendications de 1 à 5,
sachant qu'une surface de la couche de phosphore (45, 45a) qui est opposée à la surface principale (452, 452e) de la couche de phosphore (45, 45a) faisant face au substrat (41) inclut une région qui doit être irradiée avec la lumière d'excitation pour exciter le phosphore, la région présentant une rugosité de surface avec une longueur d'onde supérieure ou égale à une longueur d'onde de la lumière d'excitation.

7. L'élément émetteur de lumière (4, 4A, 4B, 4C) d'après l'une quelconque des revendications de 1 à 5,
sachant que la surface principale (452, 452e) de la couche de phosphore (45, 45a) qui fait face au substrat (41) inclut une région qui doit être irradiée par la lumière d'excitation pour exciter le phosphore, la région présentant une rugosité de surface avec une longueur d'onde supérieure ou égale à une longueur d'onde de la lumière d'excitation.

8. Un dispositif d'éclairage (1), comprenant :
l'élément émetteur de lumière (4, 4A, 4B, 4C) d'après l'une quelconque des revendications de 1 à 7 ; et
une source lumineuse (2) qui émet une lumière d'excitation pour exciter le phosphore de l'élément émetteur de lumière (4, 4A, 4B, 4C).
